# EUROPEAN PATENT APPLICATION

(11) **EP 4 621 664 A1**
(43) Date of publication of application: **24.09.2025**
(21) Application number: 25164235.1
(22) Date of filing: 17.03.2025
(51) Int. Cl.: G06N 10/40

(54) **QUANTUM PROCESSOR ON A CHIP**

(30) Priority: 20.03.2024 US 202418610582
(71) Applicant: Quantum Transistors Technology Ltd., 516713500 Binyamina (IL)
(72) Inventor: Agranov, Gennadiy, San Jose, 95125 (US); Ferreira de Lima, Thomas, Princeton, 08542 (US); Bayn, Igal, New York, 10021 (US); Tordjman, Moshe, 3244718 Haifa (IL)
(74) Representative: Beck Greener LLP

(57) **Abstract**

A quantum computing device includes an electronic integrated circuit (IC) chip (102, 104). The IC chip includes a first array of optical sensors (108) and a photonic integrated circuit (PIC) (106) disposed on the electronic IC chip. The PIC includes a network of optical waveguides (118), which have respective inputs coupled to receive optical radiation and outputs coupled to deliver the optical radiation to the optical sensors. The IC chip further includes a second array of qubits (114) disposed on the PIC and configured to perform quantum operations and responsively to results of the quantum operations, to output the optical radiation into the inputs of the optical waveguides.

## Description

The present invention relates generally to quantum computing, and particularly to quantum processors.

Quantum computers apply principles of quantum physics in solving computational problems and have the potential to perform certain computations far more efficiently than existing digital (classical) computers. The basic building block of a quantum computer is the qubit. Quantum computers comprise quantum gates built up from qubits, including single-qubit, two-qubit, and multi-qubit gates.

Current quantum computers utilize quantum hardware that requires cooling to deep cryogenic temperatures. As a result, current quantum computers are very large and power-hungry. They additionally require complicated cryogenic systems for operation, and do not allow the use of standard silicon technology for the control of the qubits and for data processing in close proximity with the qubits and the photon detectors (i.e., in the same cryogenic volume). Moreover, such a configuration limits the ability to scale quantum computers to a higher number of qubits.

Examples described hereinbelow seek to provide improved designs and fabrication methods for quantum computers.

In accordance with an embodiment of the present invention, there is provided a quantum computing device, including an electronic integrated circuit (IC) chip, which includes a first array of optical sensors. A photonic integrated circuit (PIC) is disposed on the electronic IC chip and includes a network of optical waveguides, which have respective inputs coupled to receive optical radiation and outputs coupled to deliver the optical radiation to the optical sensors. A second array of qubits is disposed on the PIC and is configured to perform quantum operations and responsively to results of the quantum operations, to output the optical radiation into the inputs of the optical waveguides.

In embodiments, the PIC includes further optical waveguides coupled to convey excitation radiation from one or more radiation sources to the qubits.

In embodiments, the device includes one or more lasers disposed on the PIC and coupled to input the excitation radiation into the further optical waveguides.

In embodiments, the network of optical waveguides includes at least one optical switch configured to switch the optical radiation between selected waveguides. The at least one optical switch may include an electrically controllable Mach-Zehnder interferometer (MZI).

In embodiments, the first array of optical sensors includes avalanche detectors, such as single-photon avalanche diodes (SPADs), for example back-illuminated SPADs.

In embodiments, the IC chip includes a silicon (Si) substrate.

In embodiments, the waveguides include silicon nitride (Si₃N₄) waveguides disposed on a layer of silicon dioxide (SiO₂) and encapsulated in an encapsulation layer.

In embodiments, the optical waveguides are configured to output the optical radiation to the optical sensors by evanescent wave coupling. The device may include an anti-reflective (AR) coating disposed between the waveguides and the IC chip and configured to cause leakage of the optical radiation from the waveguides to the optical sensors. Additionally or alternatively, the waveguides include spiral waveguides disposed over the optical sensors so as to enhance leakage of the optical radiation to the optical sensors.

In embodiments, the PIC includes turning mirrors at the outputs of the waveguides to reflect the optical radiation toward the optical sensors.

In embodiments, the qubits include solid-state chiplets, for example containing crystal defects. In embodiments, the chiplets include diamond, and the defects include color centers in the diamond.

In embodiments, the IC chip includes control and processing circuitry coupled to the optical sensors. Additionally, the control and processing circuitry is further coupled to components on the PIC by through-silicon vias.

In embodiments, the qubits and the IC chip are configured to operate at a temperature equal to or exceeding 77 degrees Kelvin. In one example, the qubits and the IC chip are configured to operate at room temperature.

In embodiments, the first array of the optical sensors includes a linear array.

In embodiments, the first array of the optical sensors includes a two-dimensional array. In one example, the two-dimensional array includes first optical sensors, which are coupled to receive the optical radiation, and second optical sensors, which are coupled to monitor a performance of components on the PIC.

There is also provided, in accordance with another embodiment of the present invention, a quantum computing device, including an electronic integrated circuit (IC) chip including a first array of avalanche detectors, a second array of qubits configured to perform quantum operations and to output optical radiation responsively to results of the quantum operations, and a network of optical waveguides coupled to convey the radiation output by the qubits in the second array to the avalanche detectors in the first array.

In embodiments, the network of optical waveguides includes an array of optical fibers.

In embodiments, the device includes a photonic integrated circuit (PIC), wherein the optical waveguides are disposed on the PIC. In one example, the network of waveguides is configured to convey the radiation to the avalanche detectors by edge coupling from an edge of the PIC.

In embodiments, the PIC is overlaid on the electronic IC chip.

In embodiments, the device includes a cryogenic enclosure, wherein the qubits are contained in the cryogenic enclosure, and the optical waveguides are coupled to convey the optical radiation out of the cryogenic enclosure.

There is further provided, in accordance with yet another embodiment of the present invention, a method for quantum computing, which includes providing an electronic integrated circuit (IC) chip including a first array of optical sensors. A photon integrated circuit (PIC) is overlaid on the electronic IC chip, the PIC including a network of optical waveguides, which have respective inputs coupled to receive optical radiation and outputs coupled to deliver the optical radiation to the optical sensors. A second array of qubits is placed on the PIC and is configured to perform quantum operations so that responsively to results of the quantum operations, the qubits output the optical radiation into the inputs of the optical waveguides.

There is additionally provided, in accordance with another embodiment of the present invention, a method for quantum computing, which includes providing an electronic integrated circuit (IC) chip comprising a first array of avalanche detectors. A second array of qubits is provided, configured to perform quantum operations and to output optical radiation responsively to results of the quantum operations. A network of optical waveguides is coupled to convey the radiation output by the qubits in the second array to the avalanche detectors in the first array.

The present invention will be more fully understood from the following detailed description of the examples thereof, taken together with the drawings in which:
Fig. 1 is a schematic sectional view of a quantum computing device;
Fig. 2 is a schematic top view of a quantum computing device;
Fig. 3 is a schematic partial sectional view of a quantum computing device;
Figs. 4 and 5 are schematic sectional and top views, respectively, of a quantum computing device;
Fig. 6 is a schematic top view of a quantum computing device;
Fig. 7 is a schematic sectional view of a quantum computing device;
Fig. 8 is a schematic top view of a quantum computing device;
Fig. 9 is a schematic partial sectional view of a quantum computing device;
Figs. 10A and 10B are schematic frontal views of a detector array, illustrating coupling of light from an optical fiber to the array;
Fig. 11 is a schematic top view of a quantum computing device; and
Fig. 12 is a schematic sectional view of a quantum computing device.

### OVERVIEW

Despite the promise and potential advantages of quantum computing, fabricating compact, low-power, and readily scalable quantum computers faces multiple technological hurdles. One of these hurdles is the difficulty of integrating standard silicon-based electronics into a quantum computer due to the need to operate these computers at ultra-low cryogenic temperatures, near absolute zero.

Some examples of the present invention that are described herein address these problems by combining an electronic integrated circuit (IC) chip, a photonic integrated circuit (PIC), and an array of qubits, performing quantum operations, into a single-chip quantum computing device. In some examples, the qubits are based on crystal defects, for example diamond chiplets with color centers, which may be operated at higher cryogenic temperatures (such as liquid nitrogen temperature or higher), or at temperatures attainable by thermoelectric cooling, or even up to room temperature. Qubits of this kind are described, for example, in U.S. Patent Application 18/171,351, filed February 19, 2023, whose disclosure is incorporated herein by reference. Alternatively, other types of solid-state qubits may be used. Higher cryogenic or room-temperature operation, in turn, permits the use of standard silicon (Si) technology for fabricating the electronic IC chip, as well as the PIC.

The electronic IC chip comprises an array of optical sensors. For high sensitivity, it is desirable that the sensors comprise avalanche detectors, or more specifically single-photon avalanche photodiodes (SPADs). The electronic IC chip further comprises driving and processing electronics for the sensors, the qubits, and possibly driving electronics for lasers, modulators, and optical switches. The electronic IC chip may also comprise circuitry for controlling quantum computation operations carried out by the qubits.

The qubits are typically fabricated and tested separately, either as individual chiplets or as chiplet arrays, and mounted on the PIC, for example using pick-and-place techniques that are known in the art. The PIC further comprises a network of optical waveguides, which convey the optical radiation indicating the results of the quantum operations from the qubits to the sensors. The network of waveguides may comprise optical switches, such as electrically controllable Mach-Zehnder interferometers (MZIs), for switching the optical radiation between selected waveguides.

Sources of optical radiation, such as diode lasers, may be disposed on the PIC and coupled by optical waveguides to provide excitation radiation to the qubits.

In other examples of the present invention, the qubits may be coupled to the avalanche detectors by optical fibers, in addition to or instead of waveguides on a PIC. Using arrays of optical fibers as waveguides makes it possible to separate the qubits from the detectors and associated electronics. This arrangement is advantageous when the qubits require cryogenic cooling, as the arrangement permits holding the qubits in a cryogenically cooled volume, while the detectors and electronics can be at room temperature.

### SYSTEM DESCRIPTION

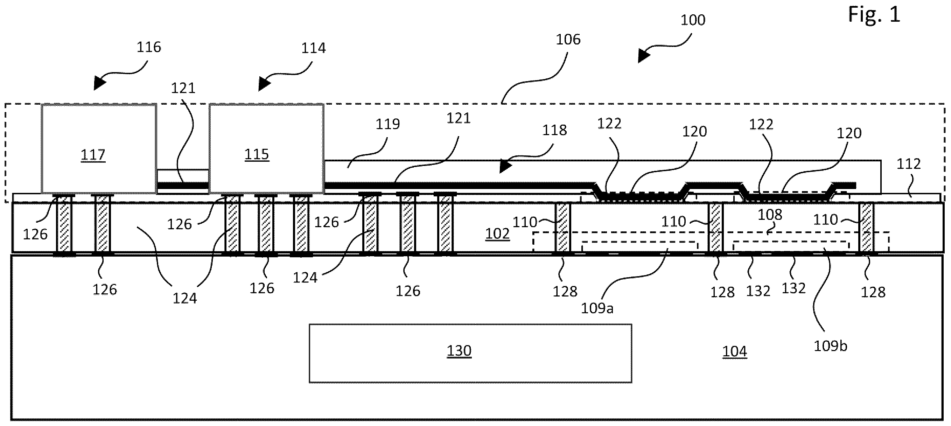

Fig. 1 is a schematic sectional view of a quantum computing device 100, in accordance with an example of the invention.

Device 100 comprises two Si substrates 102 and 104, and a PIC 106. Substrates 102 and 104 are bonded to each other using, for example, hybrid copper-to-copper (Cu-to-Cu) bonding technology, enabling electrical contacts between the two substrates. Substrate 102 comprises a SPAD array 108, comprising SPADs 109, of which two pixels (individual SPADs) 109a and 109b are shown. The pixels of SPAD array 108 are isolated from each other by deep-trench isolations (DTI) 110. SPADs 109 form either a one-dimensional or a two-dimensional array, as will be further detailed hereinbelow. As the optical radiation from PIC 106 (as detailed below) impinges on SPADs 109 through substrate 102, the SPADs are termed "back-side illuminated (BSI) SPADs." BSI SPADs are suitable for the described example due to a high fill factor of the pixels of SPAD array 108 and the convenience of integrating the SPAD array and its readout circuitry (within circuitry 130 on substrate 104, described hereinbelow) with other components of device 100. Finally, the absence of interconnect layers on the surface of BSI SPADs 109 significantly simplifiers integration with PIC 106 and coupling of waveguides 121 (detailed below) to the SPADs.

To further increase the detection probability by SPADs 109 for long-wavelength photons propagating in waveguides 121, a customized doping profile and/or an electric field are applied to substrate 102 for directing generated carries toward a multiplication region within SPADs 109.

Alternative examples may comprise front-side illuminated SPADs, wherein optical radiation impinges on the SPADs without traversing their substrate.

PIC 106 is fabricated on a dielectric layer 112, comprising a material such as silicon dioxide (SiO₂), deposited on substrate 102. A qubit array 114, comprising of chiplets of qubits 115, detailed hereinbelow, and a laser array 116 of excitation lasers 117 are picked and placed on PIC 106, after having been fabricated and tested for performance. Qubits 115 and lasers 117 may be placed individually or as chips comprising multiple qubit chiplets or lasers, respectively.

A waveguide network 118, comprising waveguides 121, couples lasers 117 to qubits 115, and further couples the qubits to respective SPADs 109 of SPAD array 108. Waveguides 121 typically comprise silicon nitride (Si₃N₄, also commonly abbreviated as SiN), deposited on dielectric layer 112 and encapsulated in a dielectric material 119, such as SiO₂. The dimensions of waveguides 121 are typically selected so that the guided waves propagate only in a single transverse mode of optical radiation, i.e., so that the waveguides function as single-mode waveguides. Waveguide network 118 further comprises optical switches, as will be detailed hereinbelow.

In the described example, for coupling optical radiation from waveguides 121 to SPADs 108, windows 120 are opened in layer 112 above respective SPADs 109a, 109b, ..., and an anti-reflective coating (ARC) 122 is deposited in the windows between the waveguides and substrate 102. The application of ARC 122 causes the optical radiation propagating in waveguides 118 to experience frustrated total internal reflection (frustrated TIR) at the ARC and to leak toward SPADs 109a, 109b, ..., through respective windows 120.

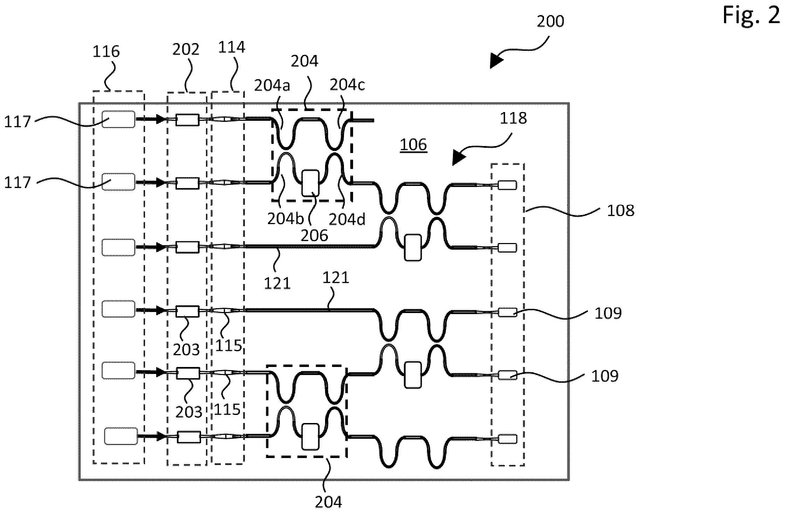

Substrate 104 comprises electronic circuitry 130, which receives, amplifies, and processes signals output by SPADs 109 in array 108. Circuitry 130 may also control the initialization and manipulation of the quantum states of qubits 114. Circuitry 130 also drives and shapes the pulses of lasers 117 and drives the phase modulators of the optical switches in waveguide network 118, as detailed in Fig. 2, hereinbelow. Based on these functions, circuitry 130 initiates quantum computing operations by qubits 115 and reads out the results of the operations based on the signals received from SPAD array 108.

Assuming device 100 is capable of operating at higher cryogenic or room temperature, circuitry 130 can be fabricated using conventional or slightly modified IC technologies, such as complementary metal-oxide-semiconductor (CMOS) Si technology. Circuitry 130 is coupled to qubits 115, lasers 117, and the optical switches by through-silicon vias (TSVs) 124 and contact pads 126. DTIs 110 are coupled to circuitry 130 (but not to PIC 106) via contact pads 128 for setting the potentials of the DTIs. SPADs 109a, 109b, ..., are coupled to circuitry 130 through contact pads 132.

Qubits 115 comprise solid-state chiplets, which may be based on crystal defects. For example, qubits 115 may comprise diamond-based quantum transistors with nitrogen-vacancy (NV) color centers, as described in the above-mentioned U.S. Patent Application 18/171,351. Lasers 117 comprise modulatable solid-state lasers, typically emitting coherent optical radiation at wavelengths 532nm and 637nm, although lasers emitting at other wavelengths may also be used. Optionally, lasers 117 may be modulated in an on-off keying mode using separate modulators on PIC 106, as will be further detailed hereinbelow.

For performing quantum computation operations on device 100, lasers 117 emit optical radiation through waveguides 118 to selected qubits 115, initializing their respective quantum states in conjunction with electrical potentials applied by circuitry 130. Lasers 117 then excite state transitions of qubits 115 to perform quantum operations, including multi-qubit entanglement.

Following the quantum operations, lasers 117 cause qubits 115 to emit photons that are indicative of the qubit states. These photons are received by waveguide network 118 from respective qubits 115, possibly switched between the waveguides by optical switches, and then carried to SPAD array 108. The photons are coupled from waveguides 121 to respective SPADs 109 through frustrated TIR at windows 120, as described hereinabove. As shown in Fig. 1, two SPADs 109a and 109b are coupled in succession to waveguide 121. The use of two (or more) SPADs in this manner is advantageous for improving the probability of capturing a photon carried in waveguide 121 and thus increasing the efficiency of detection.

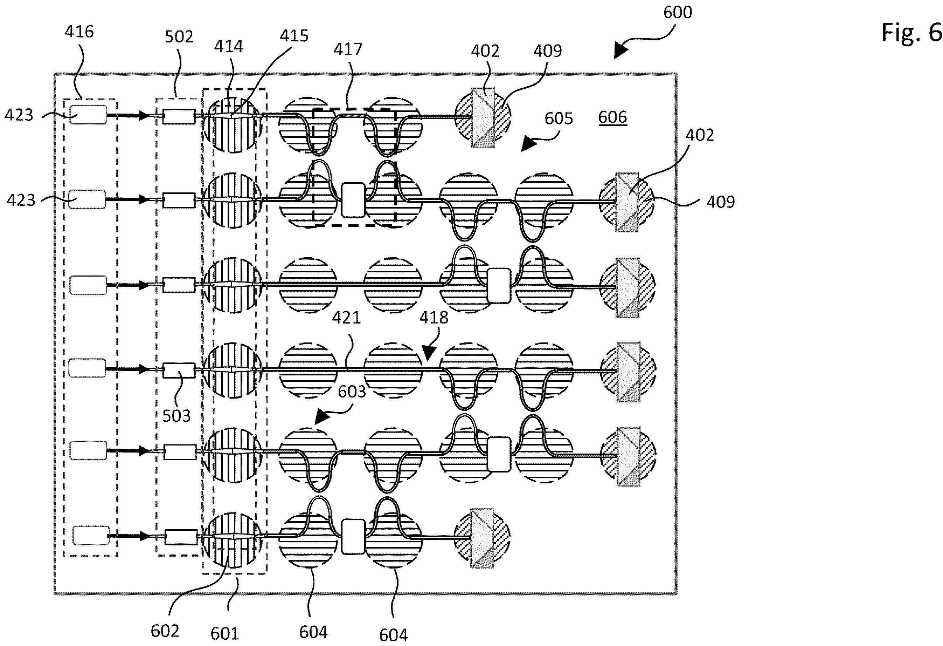

In addition, SPADs 109 in array 108 may be utilized for monitoring the performance of qubits 115 based on photon statistics and for monitoring propagation losses in waveguides 121 based on scattered photons, as will be further detailed in Fig. 6.

Fig. 2 is a schematic top view of a quantum computing device 200, in accordance with another example of the invention. Device 200 is similar to device 100 (Fig. 1), with the addition of an array 202 of external modulators 203 and with optical switches 204 explicitly shown in PIC 106. Thus, device 200 can be considered a more detailed version of the example shown in Fig. 1. Items identical or similar to those in Fig. 1 are identified with the same labels. In device 200, similarly to device 100, an array 114 of qubits 115, an array 116 of lasers 117, and array 108 of SPADs 109, are disposed on or coupled to PIC 106 and are coupled together by waveguides 121. Modulators 203, coupled to circuitry 130, are disposed on PIC 106 between respective lasers 117 and qubits 115, and coupled to them by waveguides 121.

Optical switches 204 on PIC 106 are coupled to waveguides 121. Each switch 204 comprises a Mach-Zehnder interferometer (MZI), switched by a phase modulator 206. Each phase modulator 206 is driven by circuitry 130 (Fig. 1) to switch the optical radiation propagating in one of two input waveguides 204a or 204b of the respective MZI 204 to one of its two output waveguides 204c or 204d. In addition to switching between the waveguides, switches 204 may be driven to compensate for fabrication imperfections of PIC 106, as well as for environmental changes. For the sake of simplicity, only one SPAD 109 is shown in Fig. 2 for each waveguide 121, as opposed to two SPADs per waveguide as in Fig. 1.

### OTHER SCHEMES FOR COUPLING FROM WAVEGUIDES TO SENSORS

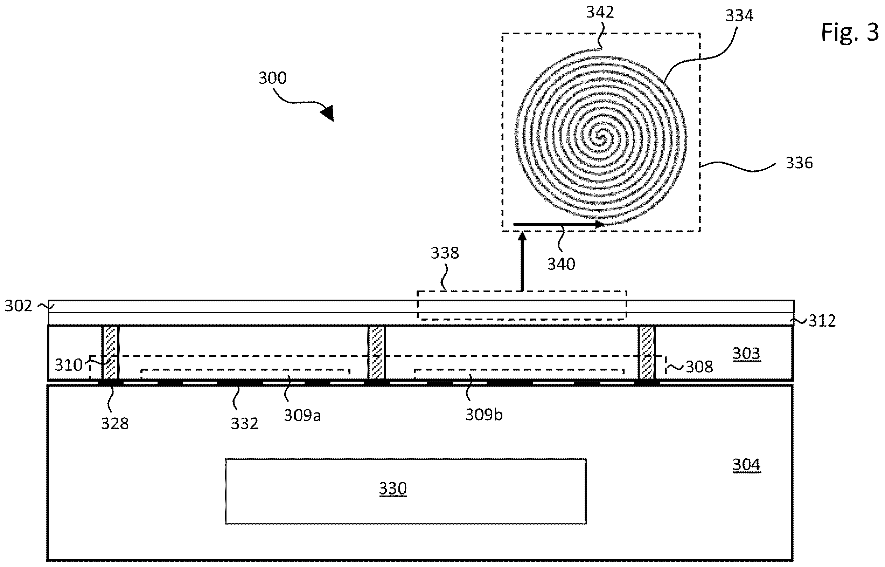

Fig. 3 is a schematic partial sectional view of a quantum computing device 300 showing evanescent coupling from a waveguide 302 to a SPAD array 308, in accordance with an example of the invention.

The example shown in Fig. 3 provides an alternative waveguide-to-SPAD coupling mechanism to that shown in Fig. 1. For the sake of simplicity, Fig. 3 shows only a partial sectional view of device 300. Device 300 comprises waveguide 302, which is separated from a Si substrate 303 by a dielectric layer 312. Substrate 303 is bonded to a Si substrate 304, similarly to substrates 102 and 104 in device 100 (Fig. 1). Substrate 303 comprises SPAD array 308 of SPADs 309, with SPADs 309a and 309b shown. Substrate 304 comprises circuitry 330, which is coupled, similarly to circuitry 130 in device 100, to SPADs 309 via contacts 332 and to DTIs 310 via contacts 328.

The evanescent coupling of optical power from waveguide 302 to SPADs 309 may be described by considering the refractive indices and dimensions of the components of device 300: The refractive index of Si substrate 303 for red wavelengths is about n_{Si} = 3.87. Waveguide 302 comprises SiN and dielectric layer 112 comprises SiO₂, with respective refractive indices n_{SiN} = 2.0 and n_{SiO2} = 1.46. For waveguide 302 having a width exceeding 0.3 µm and layer 112 having a thickness exceeding 0.3 µm, the overlap of a guided mode in the waveguide with substrate 303 is minimal, and consequently the leakage of optical power from the waveguide to the substrate is low. Reducing the cross-sectional dimensions of waveguide 302, however, for example tapering down to a cross-section of 100 nm × 300 nm, increases the overlap between the guided mode and substrate 303, thus leading to a flow of optical power from the waveguide to SPADs 309. For example, for a waveguide 302 that is separated from the active area of SPADs 309 by a 350 nm thick dielectric layer 312, tapering the waveguide cross-section down to 100 nm × 300 nm results in an increase in the leakage of optical power from the waveguide by over 45 dB/cm. In alternative examples, the width and thickness of waveguide 302, as well as the thickness of dielectric layer 312, may each be optimized to achieve maximal leakage of optical power to SPADs 309.

To further enhance the flow of optical power into substrate 303, waveguide 302 is patterned as a spiral 334, shown in an inset 336, which shows a top view of an area 338 of the waveguide. Spiral 334 is positioned above SPAD 309b in order for the optical power leaked from waveguide 302 within spiral 334 to be absorbed by the SPAD. A similar spiral may be positioned over each SPAD in array 308. Although spiral 334 is shown in Fig. 3 as a circular spiral, other forms (for example rectangular with rounded corners) may be used.

A guided wave enters spiral 334 as shown by an arrow 340. Spiral 334 forms a double spiral, turning around at its center and back-tracking its path, so that the guided wave traverses the spiral path a second time, thus doubling the length (absorption length) of waveguide 302 above SPAD 309b. A Y-splitter-based reflector may be placed at an end-point 342 of spiral 334, reflecting the guided wave for a second pass through the spiral and even further increasing the absorption length.

In order to decrease the overlap of the guided wave with substrate 303 and thus the leakage of the optical power outside the area of SPADs 309, the width of waveguide 302 may be increased, possibly to a multimode waveguide. Alternatively or additionally, modifying the thickness of dielectric layer 312 (thin above SPADs 309, thick elsewhere) may be utilized to control the leakage. Alternatively, waveguide 302 may be coupled to a separate, similar waveguide deposited on a thicker dielectric layer 312 and/or having an increased cross-section.

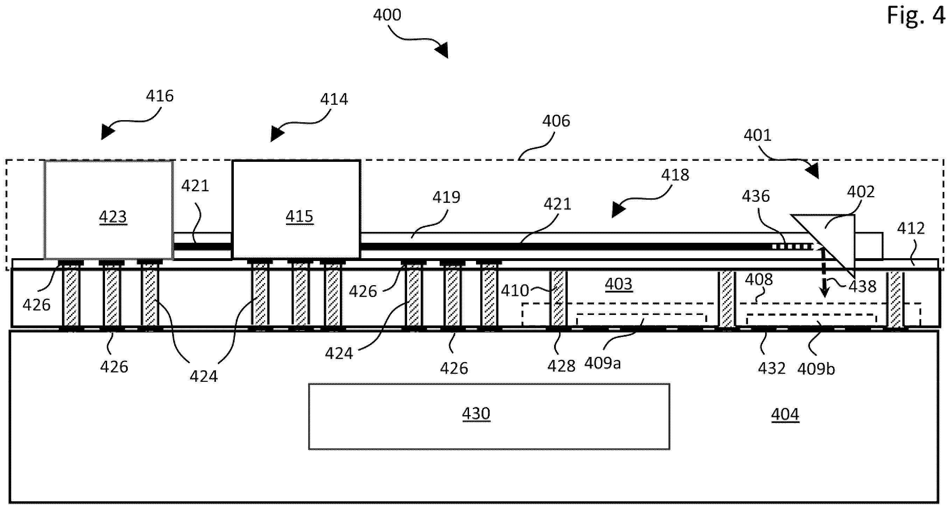

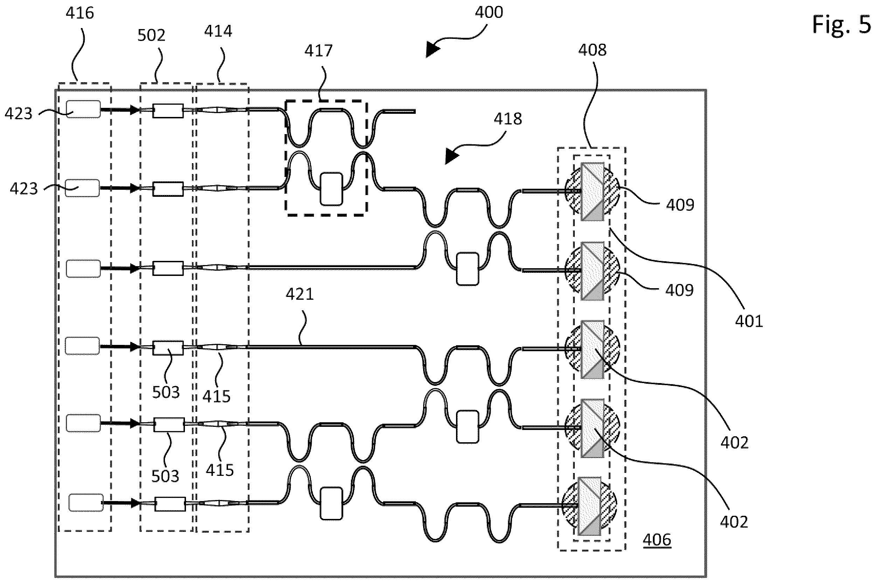

Figs. 4 and 5 are schematic sectional and top views, respectively, of a quantum computing device 400 comprising an array 401 of turning mirrors 402, in accordance with examples of the invention.

Similarly to device 100 (Fig. 1), device 400 comprises Si substrates 403 and 404, with substrate 403 comprising a SPAD array 408, comprising SPADs 409, and with substrate 404 comprising circuitry 430. A PIC 406, disposed on substrate 403, has, similarly to device 100, a network 418 of waveguides 421 formed on a dielectric layer 412 and encapsulated in a dielectric material 419. PIC 406 further comprises, similarly to device 100, respective arrays 414 and 416 of qubits 415 and lasers 423, as well as optical switches 417 (shown in Fig. 5). Circuitry 430 is coupled through TSVs 424 and contact pads 426 to qubits 415, lasers 423, and optical switches 417, through contact pads 428 to DTIs 410, and through contact pads 432 to SPADs 409 in SPAD array 408.

In the sectional view of Fig. 4, the optical radiation propagating in waveguide 421 is coupled to SPAD 409b by mirror 402, which intercepts the propagating optical radiation. Mirror is typically oriented at 45° relative to the direction of propagation in waveguide, although other mirror configurations may alternative be used. The coupling is shown by arrows 436 and 438, wherein arrow 436 denotes the optical radiation propagating in waveguide 421, and arrow 438 shows the radiation reflected from mirror 402. Each mirror 402 in array 401 is aligned with a respective SPAD 409. SPAD 409a may be utilized in this example for monitoring scattering from waveguide 421, as will be further detailed hereinbelow. The non-45-degree surfaces of mirror 402 can be coated with an anti-reflective coating for avoiding reflections of back-scattered photons from SPAD 409b. Mirror 402 (or another optical element in PIC 406 can also comprise a bandpass filter coating, for example to allow the red output radiation from qubit 414 to reach SPAD 409b while blocking radiation in other bands output by laser 423.

Fig. 5 also shows external modulators 503 in a modulator array 502 on device 400. Phase-modulated MZI optical switches 417, similar to switches 204 (Fig. 2), are explicitly shown. Items identical or similar to those in Fig. 4 are indicated with the same labels. Array 401 of mirrors 402 deflects radiation from waveguides 421 to impinge on SPADs 409 in array 408, for reading out the signals output by qubits 415. Array 408 in this case is a linear array, without additional SPADs for monitoring system performance.

Fig. 6 is a schematic top view of a quantum computing device 600, in which the SPAD array includes SPADs 602 and 604 for system monitoring, in accordance with an example of the invention. Items identical or similar to those in Figs. 4 and 5 are identified with the same labels.

Device 600 comprises a PIC 606, which is similar to PIC 406 of device 400 (Figs. 4 and 5). The addition of SPADs 602 and 604 requires corresponding modifications to the Si substrates below PIC 606 (Si substrates not shown). SPADs 602 are arranged in a one-dimensional (linear) sub-array 601, whereas SPADs 409 and 604 define respective two-dimensional sub-arrays 605 and 603. SPADs 409 are used, as described hereinabove, for receiving the optical signals sent by qubits 415 through waveguides 421, which are coupled to the SPADs by 45-degree mirrors 402.

SPADs 602 are used for monitoring the performance of qubits 415, with each SPAD 602 located under a respective qubit. Photons scattered from qubits 415 are received by respective SPADs 602, and the statistics of the scattered photons provide diagnostic information for the qubits.

SPADs 604 are located under waveguides 421 and are used for monitoring the performance of the waveguides through scattered photons. Monitoring statistics of the scattered photons yields an estimate of the scattering losses of the waveguides. Furthermore, this type of monitoring allows in-line and real-time analysis of the splitting ratios in waveguide taps or splitters, for example switches 417. This monitoring provides feedback regarding temperature and other ambient effects affecting the functionality of PIC 606 and enables corrective actions through phase control of switches 417.

### ALTERNATIVE SCHEMES FOR COUPLING QUBITS TO SENSORS

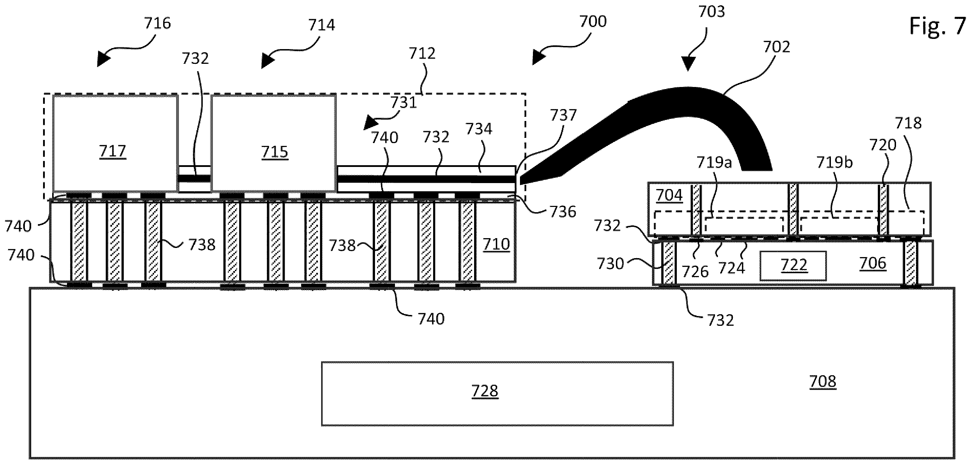

Fig. 7 is a schematic sectional view of a quantum computing device 700 comprising an array 702 of optical fibers, in accordance with an example of the invention.

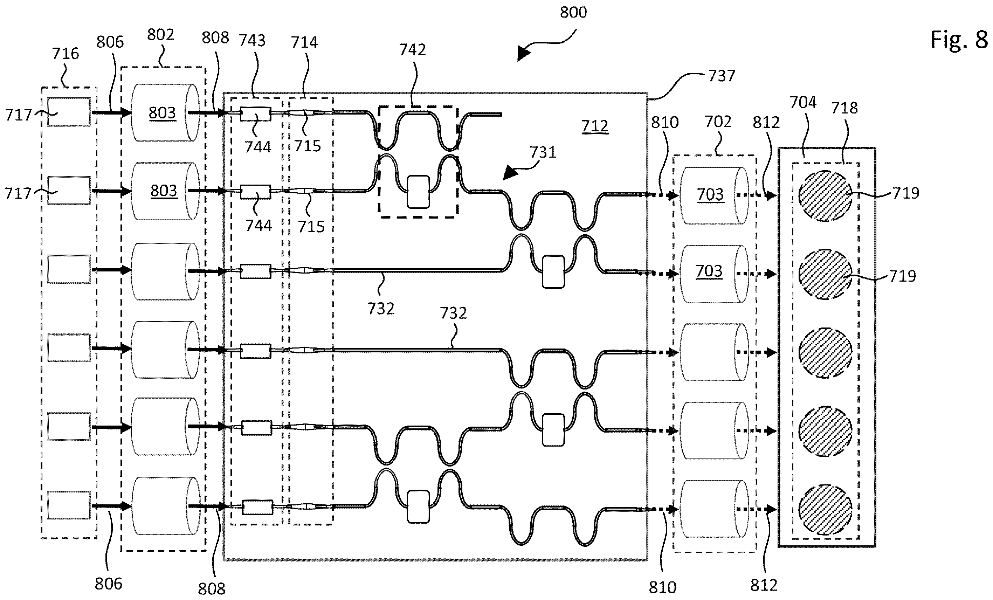

Device 700 comprises four Si substrates 704, 706, 708, and 710, a PIC 712, an array 714 of qubits 715, and an array 716 of lasers 717. Device 700 may further comprise optical switches and modulators (shown in Fig. 8).

Substrate 704 comprises an array 718 of back-illuminated SPADs 719, with two SPADs 719a and 719b explicitly shown. Neighboring SPADs are isolated from one another by DTIs 720. Substrate 706 comprises control and processing circuitry 722 for SPADs 719 with the circuitry coupled to the SPADs and to DTIs 720 through contact pads 724 and 726, respectively. Substrates 704 and 706 are bonded to each other, after which the "sandwich" of the two substrates is bonded to substrate 708.

Substrate 708 comprises circuitry 728, which drives qubits 715, lasers 717, and other components of PIC 712, and controls and synchronizes quantum computing operations by qubits 715. The circuit and detection components in device 700 are coupled together through TSVs 730 and contact pads 732. PIC 712 comprises a network 731 of waveguides 732, on a dielectric layer 736, encapsulated in an encapsulation layer 734. Waveguides 732 couple optical radiation emitted by lasers 717 to qubits 715, and further couple radiation output by the qubits to an output edge 737 of PIC 712. After the fabrication of PIC 712 on substrate 710, the assembly is bonded to substrate 708. Qubits 715, lasers 717, and other electrical components are coupled to circuitry 728 through TSVs 738 and contact pads 740.

The integration of device 700 is finalized by coupling the ends of waveguides 732 at output edge 737 of PIC 712 to SPAD array 718 using fibers 703 in array 702 (fibers 703 shown in Fig. 8). Each fiber 703 connects a respective waveguide 732 to a corresponding SPAD 719 or group of SPADs. Alternatively, instead of fiber array 702, the coupling from output edge 737 to SPADs 719 may be realized by a 3D-polymer written connection, such as photonic wire-bonding.

Fig. 8 is a schematic top view of a quantum computing device 800 showing the use of fiber arrays 802 and 702 for input and output, respectively, to and from PIC 712, in accordance with an example of the invention. Device 800 is similar to device 700, with the exception that lasers 715 are external to PIC 712, and are coupled to waveguides 732 through optical fibers 803 in array 802. Items that are identical or similar to those in Fig. 7 are indicated with the same labels.

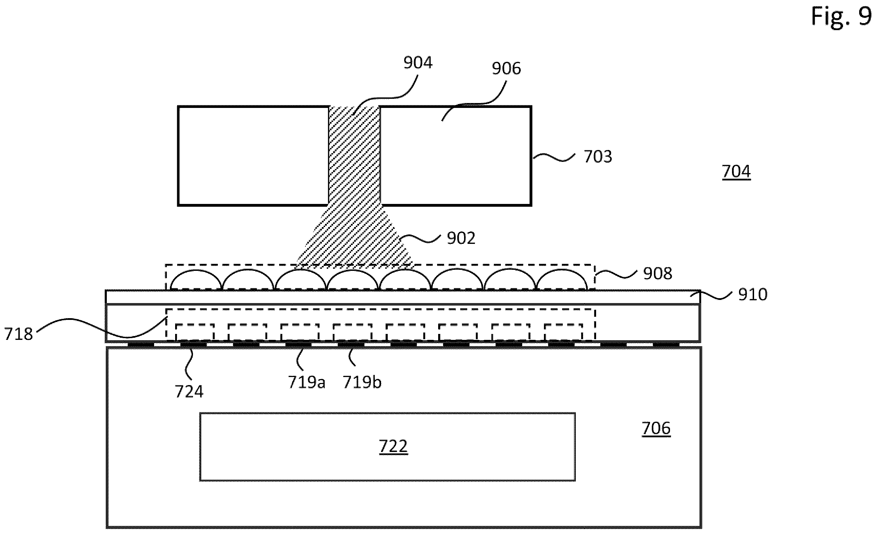

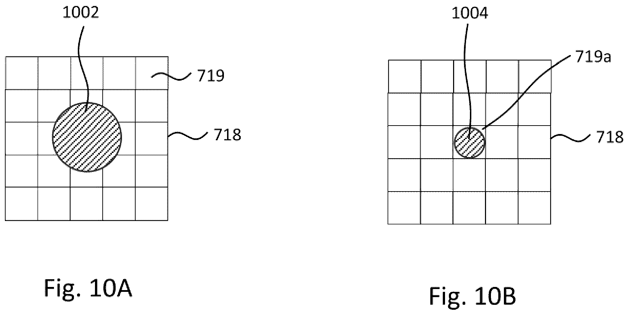

Optical radiation emitted by lasers 717 is coupled to respective fibers 803 in array 802 as shown by arrows 806. The radiation is further coupled from fibers 803 to respective waveguides 732 as shown by arrows 808. The radiation is modulated by modulators 744 in modulator array 743 on PIC 712, and the modulated radiation is input to qubits 715. The optical radiation output by qubits 715 is processed by optical switches 742 on PIC 712. The output radiation is then emitted from waveguides 732 at edge 737 of PIC 712 and is coupled to respective fibers 703 in array 702 as shown by dashed arrows 810. The radiation is further coupled, as shown by dashed arrows 812, from each fiber 703 to either a single SPAD 719 in array 718 or to multiple SPADs, as detailed in Figs. 9 and 10A-10B hereinbelow.

Figs. 9 and 10A-10B show the coupling of fiber array 702 of device 700 to SPAD array 718, in accordance with an example of the invention. Items identical or similar to those in Figs. 7 and 8 are indicated with the same labels.

Fig. 9 shows a partial schematic sectional view of device 700. The partial view shows substrates 704 and 706 with SPAD array 718, including SPADs 719a and 719b, and control and processing circuitry 722, coupled to the SPADs through contact pads 724. A single fiber 703 of fiber array 702 (Fig. 7 and 8) is shown emitting a cone of radiation 902. Fiber 703 comprises a core 904, with a typical diameter of 10µm, and a cladding 906, with a typical outer diameter of 100µm. For concentrating radiation 902 on SPADs 719, an array of microlenses 908 is formed on an SiO₂ layer 910 deposited on substrate 704. The shape and/or type of each of microlenses 908 may be optimized to increase the efficiency of coupling radiation 902 to SPADs 719.

Fig. 10A shows a distribution 1002 of radiation on SPADs 719 in array 718 as emitted by a single fiber 703 in array 702. Distribution 1002 typically covers several SPADs 719, as shown in the figure. Active alignment of fibers 703 and calibration may be used to define a region of interest (ROI) on SPAD array 718 for each fiber.

Fig. 10B shows a distribution 1004 of radiation from a single fiber 703 in array 702 that is concentrated on a single SPAD 719a of array 718. This kind of concentration may be achieved by adjusting the distance from the exit of the fiber to the respective microlens 908 as well as by an optimized design of the microlens.

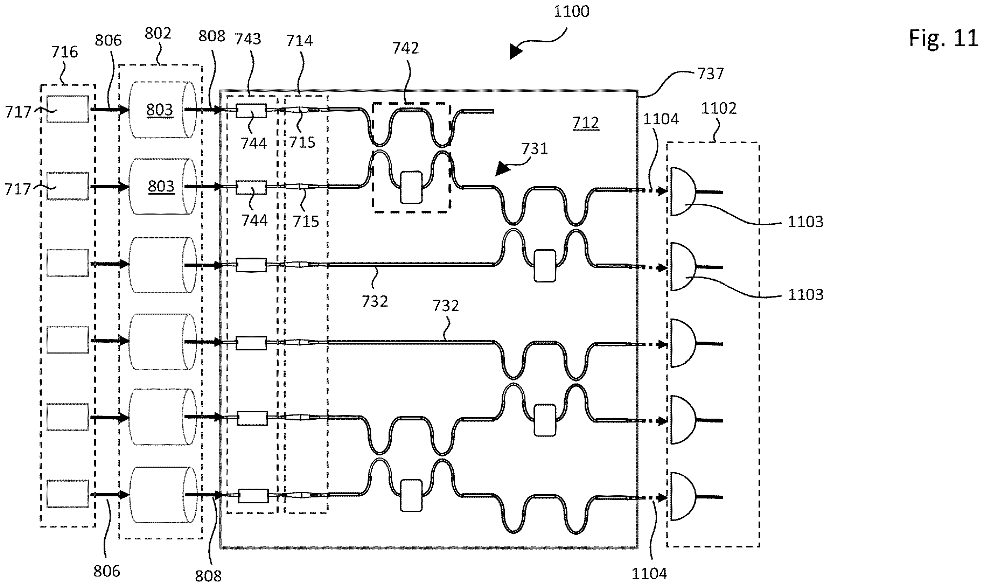

Fig. 11 is a schematic top view of a quantum computing device 1100 showing the use of edge coupling to a SPAD array 1102, in accordance with an example of the invention. Items that are identical or similar to those in Figs. 7 and 8 are indicated with the same labels.

Device 1100 is similar to device 800 (Fig. 8), with the difference that SPAD array 1102 comprising SPADs 1103 faces edge 737 of PIC 712 with the SPADs aligned in close proximity (10-50 µm) with the ends of waveguides 732 at the edge. This arrangement requires that the substrate (not shown) carrying SPAD array 1102 is turned by 90 degrees toward PIC 712. SPADs 1103 receive the optical radiation directly from the ends of waveguides 732, as shown by dashed arrows 1104. Optionally, the ends of waveguides 732 may comprise edge couplers for additional control of the emitted radiation. SPAD array 1102 comprises only a single row of SPADs 1103. An advantage of the edge coupling configuration of device 1100 is that the optical radiation exiting from waveguides 732 is received by SPADs 1103 with lower losses than in the configurations described hereinabove.

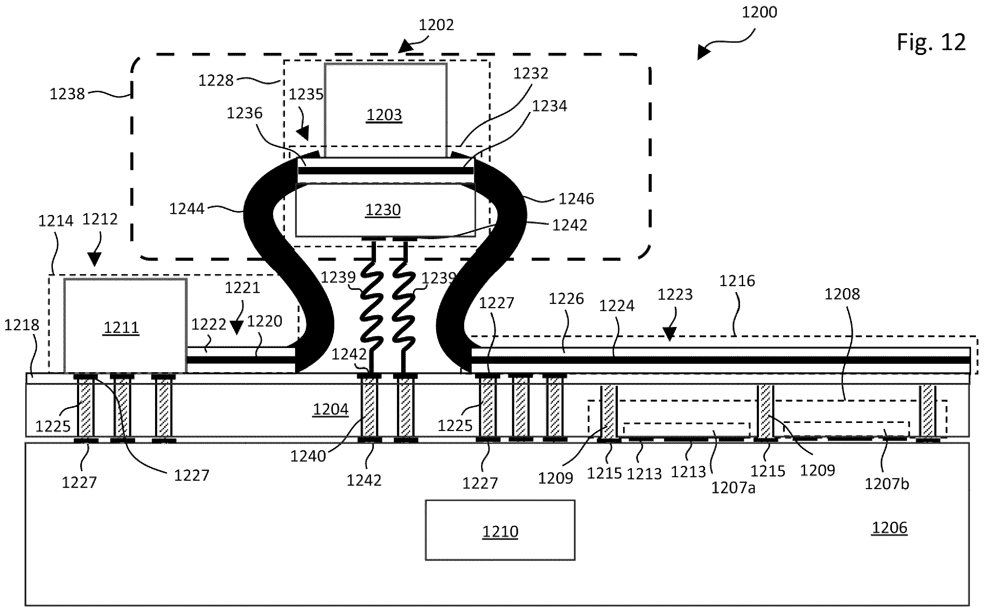

Fig. 12 is a schematic sectional view of a quantum computing device 1200 providing cryogenic cooling for a qubit array 1202, in accordance with an example of the invention. Device 1200 combines cryogenically cooled qubit array 1202 with room-temperature Si circuitry 1210.

Device 1200 comprises two Si substrates 1204 and 1206, bonded to each other. Substrate 1204 comprises a SPAD-array 1208 with SPADs 1207, with neighboring SPADs, such as SPADs 1207a and 1207b, isolated from each other by DTIs 1209. Substrate 1206 comprises circuitry 1210 for driving qubits 1203 in array 1202, excitation lasers 1211 in a laser array 1212, and modulators and optical switches (not shown), and for driving and receiving signals from SPADs 1208. Additionally, circuitry 1210 may process the outputs of quantum computing operations based on the signals received from SPADs 1207. Circuitry 1210 is coupled to SPADs 1207 through contact pads 1213 and to DTIs 1209 through contact pads 1215.

Device 1200 comprises two PICs 1214 and 1216 disposed on dielectric layer 1218. PIC 1214 comprises a first waveguide network 1221 with waveguides 1220 on a first PIC substrate 1222, as well as lasers 1211. Second PIC 1216 comprises a second waveguide network 1223 with waveguides 1224 on a PIC substrate 1226. Circuitry 1210 is coupled to PICs 1214 and 1216 through TSVs 1225 and contact pads 1227.

Device 1200 further comprises a qubit assembly 1228, comprising a qubit substrate 1230, a qubit PIC 1232, and qubit array 1202. Qubit PIC 1232 is disposed on qubit substrate 1230 and comprises a third waveguide network 1235 with waveguides 1234 within a third encapsulation layer 1236. Qubits 1203 in array 1202 are coupled to waveguides 1234 in network 1235. Alternatively, other schemes may be used for coupling optical radiation in and out of qubits 1203. Qubit assembly 1228 is enclosed in a cryogenic enclosure 1238, which is cooled down to a temperature required by qubit array 1202, such as below 10°K.

Qubit assembly 1228 is coupled to circuitry 1210 through electrical wires 1239 with low thermal conductivity, TSVs 1240, and contact pads 1242. A first optical fiber array 1244 is coupled between first PIC 1214 and qubit PIC 1232, conveying excitation radiation from lasers 1211 via waveguide network 1221 to respective qubits 1203 in array 1202. A second optical fiber array 1246 is coupled between qubit PIC 1232 and second PIC 1216, conveying optical signals from qubits 1203 in array 1202 to respective waveguides 1224, to be further coupled to SPADs 1209. Both fiber arrays 1244 and 1246 are selected for low thermal conductivity. The coupling mechanism from waveguides 1224 to SPADs 1209 is not explicitly shown in Fig. 12, but it may comprise one of the mechanisms shown in Figs. 1, 3, or 4, for example. Edge coupling, as shown in Fig. 11, may also be used with an appropriate modification of SPAD array 1208.

Embodiments of the present invention have been described with particular reference to the examples illustrated. However, it will be appreciated that variations and modifications may be made to the examples described within the scope of the appending claims..

## Claims

1. A quantum computing device, comprising:
an electronic integrated circuit (IC) chip (102, 104) comprising a first array of optical sensors (108);
a photonic integrated circuit (PIC) (106) disposed on the electronic IC chip and comprising a network of optical waveguides (118), which have respective inputs coupled to receive optical radiation and outputs coupled to deliver the optical radiation to the optical sensors; and
a second array of qubits (114) disposed on the PIC and configured to perform quantum operations and responsively to results of the quantum operations, to output the optical radiation into the inputs of the optical waveguides.

2. The device according to claim 1, wherein the PIC comprises further optical waveguides coupled to convey excitation radiation from one or more radiation sources (116) to the qubits.

3. The device according to claim 1 or 2, wherein the network of optical waveguides comprises at least one optical switch (204) configured to switch the optical radiation between selected waveguides.

4. The device according to any of claims 1-3, wherein the first array of optical sensors comprises avalanche detectors.

5. The device according to claim 4, wherein the avalanche detectors comprise single-photon avalanche diodes (SPADs) (109), wherein the SPADs are back-illuminated.

6. The device according to any of claims 1-5, wherein the optical waveguides are configured to output the optical radiation to the optical sensors by evanescent wave coupling.

7. The device according to claim 6, and comprising an anti-reflective (AR) coating (122) disposed between the waveguides and the IC chip and configured to cause leakage of the optical radiation from the waveguides to the optical sensors.

8. The device according to claim 6, wherein the waveguides comprise spiral waveguides (334) disposed over the optical sensors so as to enhance leakage of the optical radiation to the optical sensors.

9. The device according to any of claims 1-8, wherein the qubits comprise solid-state chiplets (115).

10. The device according to claim 9, wherein the qubits comprise crystal defects.

11. The device according to any of claims 1-10, wherein the IC chip comprises control and processing circuitry (130) coupled to the optical sensors, wherein the control and processing circuitry is further coupled to components on the PIC by through-silicon vias (124).

12. The device according to any of claims 1-11, wherein the qubits and the IC chip are configured to operate at a temperature equal to or exceeding 77 degrees Kelvin.

13. The device according to any of claims 1-12, wherein the first array of the optical sensors comprises a two-dimensional array, wherein the two-dimensional array comprises first optical sensors (409), which are coupled to receive the optical radiation, and second optical sensors (602, 604), which are coupled to monitor a performance of components on the PIC.

14. A quantum computing device, comprising:
an electronic integrated circuit (IC) chip (102) comprising a first array of avalanche detectors (108);
a second array of qubits (114) configured to perform quantum operations and to output optical radiation responsively to results of the quantum operations; and
a network of optical waveguides (118) coupled to convey the radiation output by the qubits in the second array to the avalanche detectors in the first array.

15. A method for quantum computing, comprising:
providing an electronic integrated circuit (IC) chip (102, 104) comprising a first array of optical sensors (108);
overlaying on the electronic IC chip a photonic integrated circuit (PIC) (106) comprising a network of optical waveguides (118), which have respective inputs coupled to receive optical radiation and outputs coupled to deliver the optical radiation to the optical sensors; and
placing on the PIC a second array of qubits (114) configured to perform quantum operations so that responsively to results of the quantum operations, the qubits output the optical radiation into the inputs of the optical waveguides.
